# EUROPEAN PATENT APPLICATION

(11) **EP 4 615 178 A1**
(43) Date of publication of application: **10.09.2025**
(21) Application number: 25158984.2
(22) Date of filing: 20.02.2025
(51) Int. Cl.: H05K 5/02, H01Q 1/12, H05K 7/18

(54) **COMMUNICATION APPARATUS AND BRACKET THEREOF**

(30) Priority: 07.03.2024 TW 113108331
(71) Applicant: Wistron NeWeb Corp., Hsinchu 308 (TW)
(72) Inventor: YANG, Lan-Chun, 308 Hsinchu (TW); CHU, Po-Chang, 308 Hsinchu (TW); WANG, Chun-Wei, 308 Hsinchu (TW)
(74) Representative: Ter Meer Steinmeister & Partner

(57) **Abstract**

A communication apparatus is provided. The communication apparatus includes a bracket and an electronic device. The bracket includes a mounting member, a carrying member and a supporting member. A first end of the supporting member is connected to the carrying member. A second end of the supporting member is connected to the mounting member. The electronic device is disposed on the mounting member.

## Description

This Application claims priority of Taiwan Patent Application No. 113108331, filed on Mar. 7, 2024.

### BACKGROUND OF THE DISCLOSURE

### Field of the Disclosure

The present disclosure relates to a bracket, and, in particular, to a bracket applied to a communication apparatus.

### Description of the Related Art

A communication equipment (e.g., communication base station) commonly comprises a host, multiple communication boxes, and a bracket. The host is arranged on top of the bracket. The communication boxes are coupled to the host and the communication boxes are arranged on the bracket. In order to provide good communication effect, these communication boxes are oriented in different directions. However, with the number and weight of the communication boxes increase, the bracket is not evenly stressed, so the bracket will be deformed, which may not only affect the reception effect, but also affect the life and reliability of the product.

### BRIEF SUMMARY OF THE DISCLOSURE

In response to the above-referenced technical inadequacies, an embodiment of the present disclosure is to provide a bracket and a communication apparatus comprising a bracket and an electronic device. The bracket comprises a mounting member, a carrying member and a supporting member. A first end of the supporting member is connected to the carrying member, and the second end of the supporting member is connected to the mounting member. The electronic device is mounted on the mounting member.

In one or more embodiments, the communication apparatus may further comprise at least one communication box, and the communication box may be arranged on the carrying member.

In one or more embodiments, the mounting member may be connected to the carrying member along a fold line.

In one or more embodiments, the first end of the supporting member may be connected to a first connecting portion of the carrying member.

In one or more embodiments, the second end of the supporting member is connected to a second connecting portion of the mounting member.

In one or more embodiments, there may be a shortest distance between the first connecting portion and the fold line.

In one or more embodiments, a total length of the supporting member may be greater than or equal to 1.2 times of the shortest distance.

In one or more embodiments, the first end of the supporting member may be connected to the first connecting portion of the carrying member in an integral manner.

In one or more embodiments, the second end of the supporting member may be connected to the second connecting portion of the mounting member in the form of locking, engaging or welding.

In one or more embodiments, the supporting member may comprise a first section, a second section and a third section.

In one or more embodiments, one end of the first section may be connected to the carrying member, the second section may be connected to the first section and the third section, the third section may be connected to the mounting member.

In one or more embodiments, the second section may abut the electronic device.

In one or more embodiments, the carrying member may comprise an extended metal element and a carrying metal element, the extended metal element may be connected to the mounting member along the fold line, the first connecting portion may be arranged on the extended metal element.

In one or more embodiments, the carrying metal element may be connected to the extended metal element, and the communication box may be arranged on the carrying metal element.

In one or more embodiments, the communication box may comprise a communication box connector.

In one or more embodiments, the carrying metal element may comprise a notch, and the communication box connector may pass through the notch.

In one or more embodiments, the communication apparatus may further comprise a cable connecting the electronic device and the communication box, the extended metal element may comprise an opening, and the cable may pass through the opening.

In one or more embodiments, the carrying member may comprise a tongue piece, which is located at the edge of the extended metal element, and the tongue piece may abut the bottom of the communication box.

In one or more embodiments, the carrying metal element may be perpendicular to the extended metal element, and/or the extended metal element may be perpendicular to the mounting member.

In one or more embodiments, the communication box may be lockingly connected to the carrying metal element, and the electronic device may be lockingly connected to the mounting member.

In another embodiment of the present disclosure, a bracket comprising a mounting member, a carrying member and a supporting member. A first end of the supporting member is connected to the carrying member, a second end of the supporting member is connected to the second connecting portion of the mounting member, and the first end of the supporting member is connected to the first connecting portion of the carrying member in an integral manner.

By employing the bracket according to the embodiments of the present disclosure, the overall structure of the bracket is strengthened as support is provided to both the mounting member and the carrying member by the supporting member. This allows for the accommodation of a greater number of communication boxes and helps prevent deformation of the bracket. As a result, the product lifetime of the communication apparatus can be extended, and its reliability increased.

### BRIEF DESCRIPTION OF THE DRAWINGS

The present disclosure can be more fully understood by reading the subsequent detailed description and examples with references made to the accompanying drawings, wherein:
FIG. 1A is a three-dimensional view of a communication apparatus of a first embodiment of the present disclosure;
FIG. 1B shows the detailed structure of a bracket of the first embodiment of the present disclosure;
FIG. 1C is another three-dimensional view of the communication apparatus of the first embodiment of the present disclosure;
FIG. 2A is a three-dimensional view of a bracket of a second embodiment of the present disclosure;
FIG. 2B shows another angle of view of the bracket of the second embodiment of the present disclosure;
FIG. 3 is a three-dimensional view of a bracket of a third embodiment of the present disclosure;
FIG. 4 is a three-dimensional view of a bracket of a fourth embodiment of the present disclosure;
FIG. 5A is a three-dimensional view of a bracket of a fifth embodiment of the present disclosure;
FIG. 5B shows another angle of view of the bracket of the fifth embodiment of the present disclosure.

### DETAILED DESCRIPTION OF THE DISCLOSURE

The following description is made for the purpose of illustrating the general principles of the disclosure and should not be taken in a limiting sense. The scope of the disclosure is best determined by reference to the appended claims.

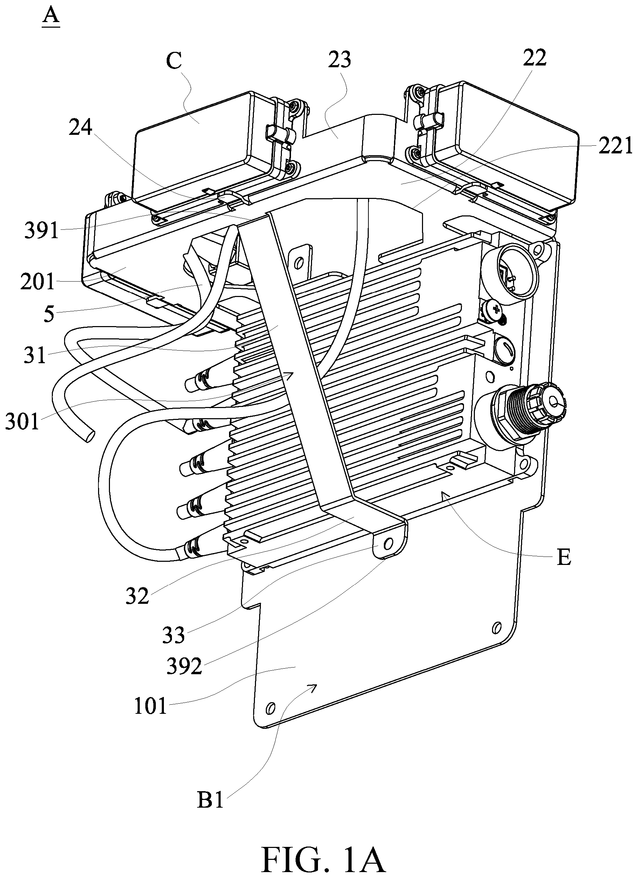

FIG. 1A is a three-dimensional view of a communication apparatus of a first embodiment of the present disclosure. With reference to FIG. 1A, the communication apparatus A comprises a bracket B1 and an electronic device E. The bracket B1 comprises a mounting member 101, a carrying member 201 and a supporting member 301, a first end 391 of the supporting member 301 is connected to the carrying member 201, and a second end 392 of the supporting member 301 is connected to the mounting member 101. The electronic device E is mounted on the mounting member 101. In one embodiment, the electronic device E may be the host of the communication apparatus A.

With reference to the FIG. 1A, in one embodiment, the communication apparatus A further comprises at least one communication box C, and the communication box C is arranged on the carrying member 201.

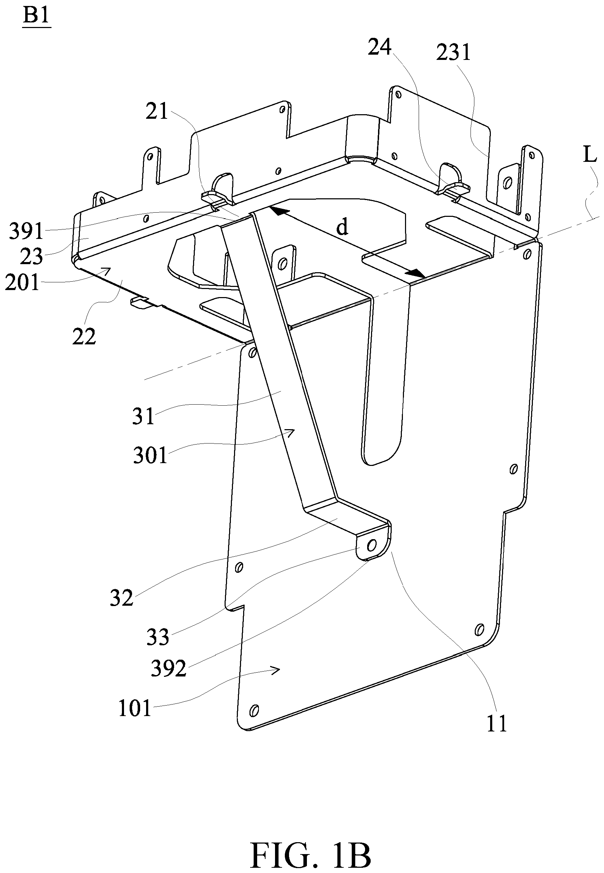

FIG. 1B shows the detailed structure of a bracket of the first embodiment of the present disclosure. With reference to the FIG. 1B, in one embodiment, the mounting member 101 is connected to the carrying member 201 along a fold line L, the first end 391 of the supporting member 301 is connected to a first connecting portion 21 of the carrying member 201, and the second end 392 of the supporting member 301 is connected to a second connecting portion 11 of the mounting member 101.

With reference to the FIG. 1B, in one embodiment, there is a shortest distance d between the first connecting portion 21 and the fold line L, and the total length of the supporting member 301 is greater than or equal to 1.2 times of the shortest distance d. In some embodiments, the total length of the support 301 may be greater than or equal to 1.5 times of the shortest distance d.

With reference to the FIG. 1B, in one embodiment, the first end 391 of the supporting member 301 is connected to the first connecting portion 21 of the carrying member 201 in an integral manner. In one embodiment of the present disclosure, the mounting member 101, the carrying member 201 and the supporting member 301 are formed in an integral manner, thereby reducing the number of components, and saving assembly time. In one embodiment, the integral forming may be a process such as punching or cutting a single metal piece to form the required structure.

With reference to the FIGS. 1A and 1B, in one embodiment, the supporting member 301 comprises a first section 31, a second section 32 and a third section 33, one end of the first section 31 is connected to the carrying member 201, the second section 32 is connected to the first section 31 and the third section 33, the third section 33 is connected to the mounting member 101, and the second section 32 is abutted to one side or bottom of the electronic device E.

With reference to the FIG. 1B, in one embodiment, the mounting member 101 is connected to the carrying member 201 along the fold line L, the connection length between the mounting member 101 and the carrying member 201 (excluding the slotted part, the total length of the connection along the fold line L) can be 26 mm, and the connection position between the mounting member 101 and the carrying member 201 can be appropriately adjusted along the fold line L. The above disclosure does not limit the present disclosure. For example, the connection length between the two mentioned above can also be other dimensions.

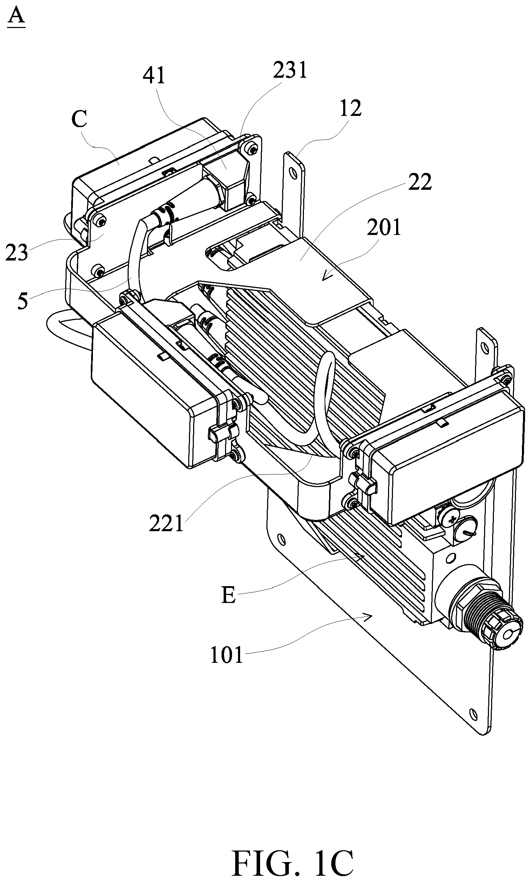

FIG. 1C is another three-dimensional view of the communication apparatus of the first embodiment of the present disclosure. With reference to the FIGS. 1B and 1C, in one embodiment, the carrying member 201 comprises an extended metal element 22 and a carrying metal element 23, and the extended metal element 22 is connected to the mounting member 101 along the fold line L, the first connecting portion 21 is positioned on the extended metal element 22, the carrying metal element 23 is connected to the extended metal element 22, and the communication box C is arranged on the carrying metal element 23.

With reference to the FIGS. 1B and 1C, in one embodiment, the communication box C comprises a communication box connecting port 41, the carrying metal element 23 comprises a notch 231, and the communication box connecting port 41 passes through the notch 231.

With reference to the FIGS. 1A, 1C, in one embodiment, the communication apparatus A further comprises a cable 5, the cable 5 connects the electronic device E and the communication box C, and the extended metal element 22 comprises an opening 221, and the cable 5 passes through the opening 221.

With reference to FIGS. 1A and 1B, in one embodiment, the carrying member 201 comprises a tongue piece 24, the tongue piece 24 is arranged on the edge of the extended metal element 22, and the tongue piece 24 abuts the bottom of the communication box C. Thus, this tongue piece 24 can provide support for the communication box C.

With reference to FIGS. 1A and 1B, in one embodiment, the carrying metal element 23 is perpendicular to the extended metal element 22, and the extended metal element 22 is perpendicular to the mounting member 101.

With reference to FIG. 1A, in one embodiment, the communication box C is lockingly connected to the carrying metal element 23, and the electronic device E is lockingly connected to the mounting member 101.

With reference to FIG. 1C, in one embodiment, the mounting member 101 further comprises a mounting portion 12. A screw can pass through the mounting portion 12 to fix the mounting member 101 on a wall surface or other fixed surface.

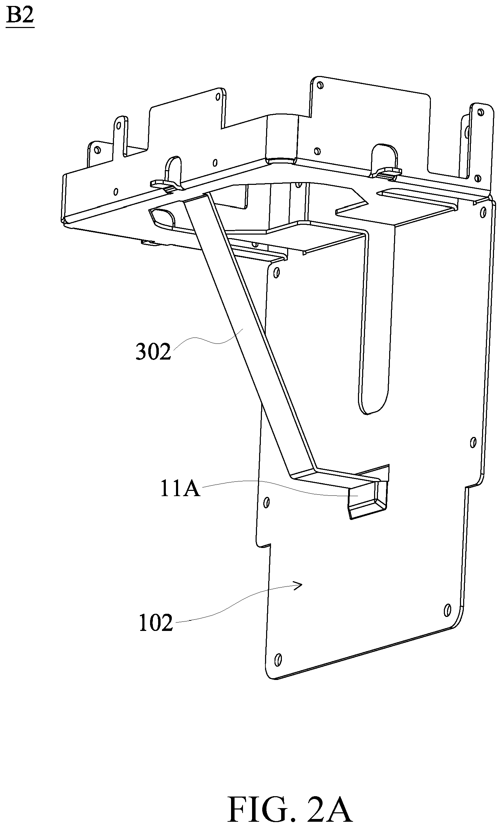

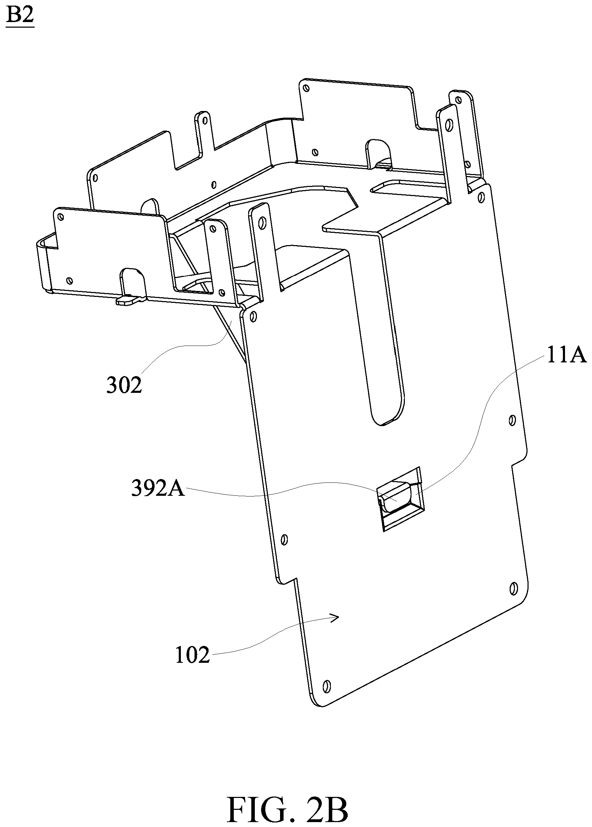

FIG. 2A is a three-dimensional view of a bracket of a second embodiment of the present disclosure. FIG. 2B shows another angle of view of the bracket of the second embodiment of the present disclosure. With reference to FIGS. 2A and 2B, in one embodiment, a second end 392A of a supporting member 302 of a bracket B2 is engaged with a second connecting portion 11A of a mounting member 102. In this embodiment, the second connecting portion 11A is a slot.

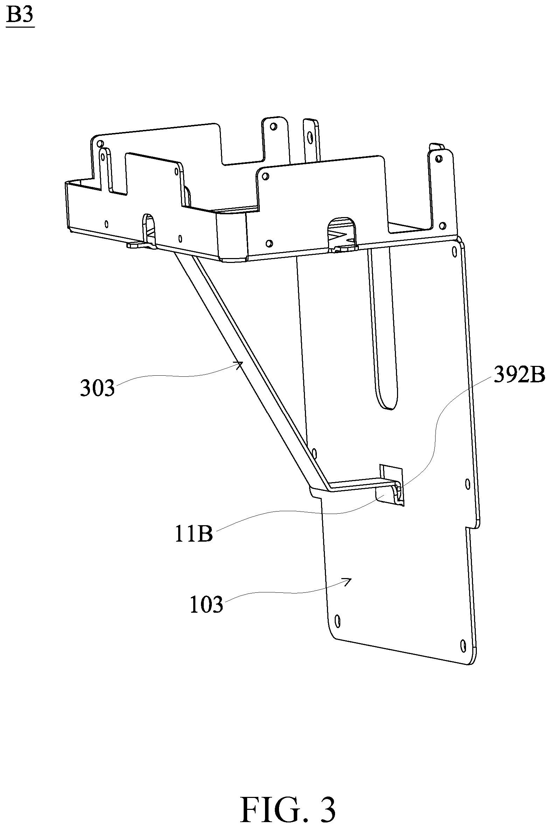

FIG. 3 is a three-dimensional view of a bracket of a third embodiment of the present disclosure. With reference to FIG. 3, in one embodiment, a second end 392B of a supporting member 303 of a bracket B3 is engaged with a second connecting portion 11B of a mounting member 103. In this embodiment, the second connecting portion 11B is a hook.

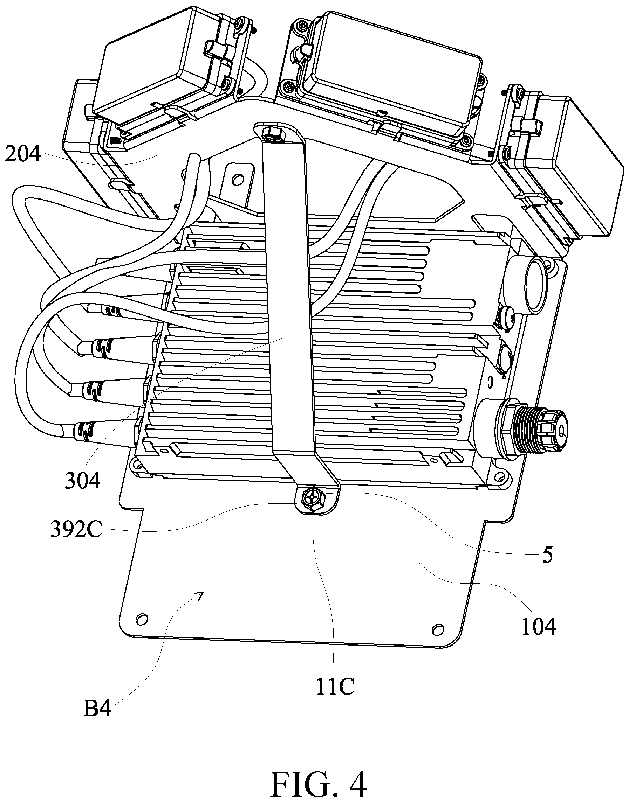

FIG. 4 is a three-dimensional view of a bracket of a fourth embodiment of the present disclosure. With reference to FIG. 4, in one embodiment, a second end 392C of a supporting member 304 of a bracket B4 is connected to a second connecting portion 11C of a mounting member 104 by a screw 5.

With reference to FIGS. 1A and 4, in the embodiment of the FIG. 1A, the carrying member 201 is substantially rectangular, and as shown in the FIG. 4, the carrying member 204 is substantially triangular, and the above disclosure does not limit the present disclosure. In another embodiment, the shape of the carrying member 204 may vary moderately.

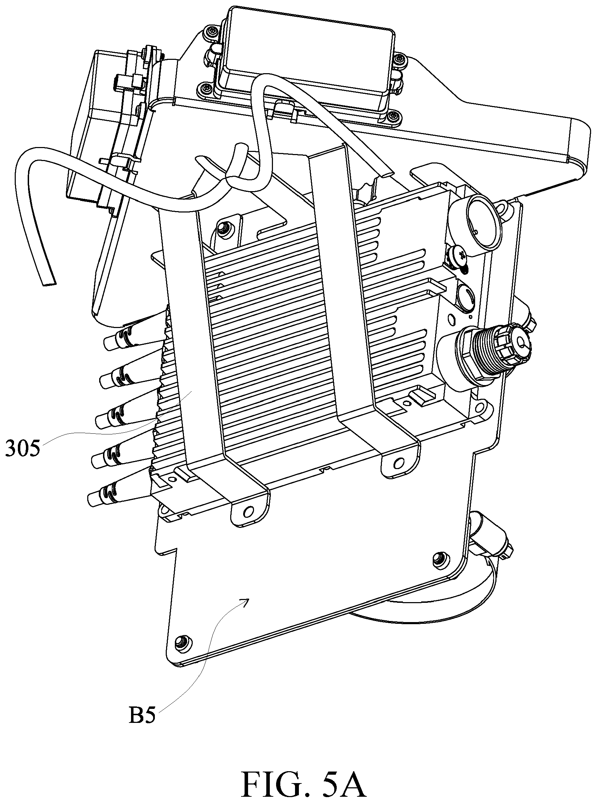

FIG. 5A is a three-dimensional view of a bracket of a fifth embodiment of the present disclosure. With reference to the FIG. 5A, in one embodiment, the bracket B5 comprises two supporting members 305. Increasing the number of the supporting member 305 can provide a stronger support effect.

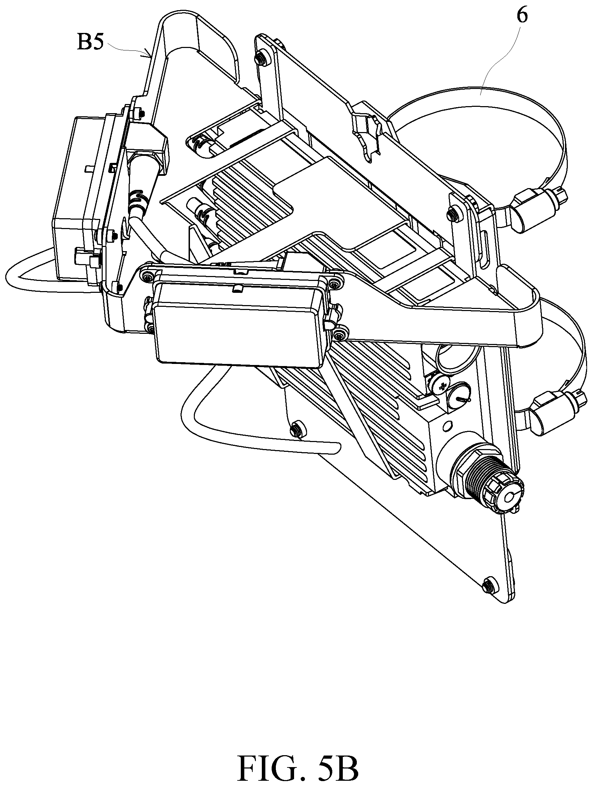

FIG. 5B shows another angle of view of the bracket of the fifth embodiment of the present disclosure. With reference to FIG. 5B, in the embodiment, the bracket B5 can be fixed on a fixed rod through a collar 6, and the above disclosure does not limit the present disclosure.

By applying the bracket according to the embodiment of the present disclosure, since the mounting member and the carrying member are supported by the supporting member, the overall structure of the bracket is strengthened, can carry a larger number of communication boxes, and avoid the situation that the bracket is deformed. This extends the product lifetime of communication apparatus and improves reliability.

While the disclosure has been described by way of example and in terms of the preferred embodiments, it should be understood that the disclosure is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A bracket (B1, B2), comprising:
a mounting member (101);
a carrying member (201); and
a supporting member (301), a first end (391) of the supporting member (301) is connected to the carrying member (201), a second end (392) of the supporting member (301) is connected to a second connecting portion (11) of the mounting member (101).

2. The bracket as claimed in claim 1, wherein the first end (391) of the supporting member (301) is connected to a first connecting portion (21) of the carrying member (201) in an integral manner.

3. The bracket as claimed in claim 1 or 2, wherein the mounting member (101) is connected to the carrying member (201) along a fold line (L).

4. The bracket as claimed in claim 3, wherein there is a shortest distance between the first connecting portion (21) and the fold line (L), and a total length of the supporting member (301) is greater than or equal to 1.2 times of the shortest distance.

5. The bracket as claimed in any one of the preceding claims, wherein the first end (391) of the supporting member (301) is connected to a first connecting portion (21) of the carrying member (201), and the second end (392) of the supporting member (201) is connected to a second connecting portion (11) of the mounting member (101), preferably the second end (392) of the supporting member (301) is connected to the second connecting portion (11) of the mounting member (101) in the form of locking, engaging or welding.

6. The bracket as claimed in any one of the preceding claims, wherein the carrying member (201) comprises an extended metal element (22) and a carrying metal element (23), the extended metal element (22) is connected to the mounting member (101) along the fold line (L), the first connecting portion (21) is positioned on the extended metal element (22), the carrying metal element (23) is connected to the extended metal element (22).

7. The bracket as claimed in claim 6, wherein the carrying metal element (23) is perpendicular to the extended metal element (22), and/or the extended metal element (22) is perpendicular to the mounting member (101).

8. The bracket as claimed in any one of the preceding claims, wherein the supporting member (301) comprises a first section (31), a second section (32) and a third section (33), one end of the first section (31) is connected to the carrying member (201), the second section is (32) connected to the first section (31) and the third section (33), the third section (33) is connected to the mounting member (101), preferably the second section (32) is parallel to the extended metal element (22).

9. A communication apparatus (A), comprising:
a bracket (B1, B2) as claimed in any one of the preceding claims,
an electronic device (E), disposed on the mounting member (10).

10. The communication apparatus as claimed in claim 9, further comprising: at least one communication box (C), and the communication box is arranged on top of the carrying member (201).

11. The communication apparatus as claimed in claim 9 or 10, wherein the second section (32) abuts the electronic device (E).

12. The communication apparatus as claimed in any one of the preceding claims 10 or 11, wherein the communication box (C) is arranged on the carrying metal element (23).

13. The communication apparatus as claimed in claim 10, 11 or 12, wherein the communication box (C) comprises a communication box connector, the carrying metal element (23) comprises a notch (231), and the communication box connector passes through the notch (231).

14. The communication apparatus as claimed in claim 10, 11, 12 or 13, wherein the communication apparatus (A) further comprising a cable (5) connecting the electronic device (E) and the communication box (C), the extended metal element (22) comprises an opening (221), and the cable (5) passes through the opening (221).

15. The communication apparatus as claimed in claims 10, 11, 12, 13 or 14, wherein the carrying member (201) comprises a tongue piece (24), which is arranged on the edge of the extended metal element (22), and the tongue piece (24) abuts the bottom of the communication box (C).
